# EUROPEAN PATENT APPLICATION

(11) **EP 4 586 321 A1**
(43) Date of publication of application: **16.07.2025**
(21) Application number: 23863466.1
(22) Date of filing: 05.09.2023
(51) Int. Cl.: H01L 27/15, H01L 33/38, H01L 33/62, G09G 3/32, H01L 25/16, H01L 25/075

(54) **LIGHT-EMITTING DEVICE**

(30) Priority: 06.09.2022 US 202263404023 P
(71) Applicant: Seoul Semiconductor Co., Ltd., Gyeonggi-do 15429 (KR)
(72) Inventor: LEE, Do Kwang, Ansan-si Gyeonggi-do 15429 (KR); HWANG, Seok Min, Ansan-si Gyeonggi-do 15429 (KR)
(74) Representative: Stolmár & Partner Patentanwälte PartG mbB
(86) International application number: PCT/KR2023/013249
(87) International publication number: WO 2024/053994

(57) **Abstract**

According to one aspect of the present invention, there may be provided a light emitting device including: a base substrate; a plurality of light-emitting cells arranged on a surface of the base substrate to emit light; a plurality of connection metal layers connecting the plurality of light-emitting cells so that the plurality of light-emitting cells are electrically connected in series; a plurality of bump pads respectively laminated on the plurality of connection metal layers; and a control unit that applies current to at least some of the plurality of bump pads to cause at least one of the plurality of light-emitting cells to emit light.

## Description

### TECHNICAL FIELD

The present invention relates to a light emitting device.

### BACKGROUND ART

With the increasing use of LED light emitting diodes in automotive light emitting devices, it is becoming increasingly important to provide light emitting devices with automotive-specific specifications to efficiently use automotive batteries. In particular, in automotive interior lighting, the voltage of an automotive battery is approximately 12 volts, but due to various external factors, the voltage of an automotive battery has a fluctuating specification. The fluctuating voltage can range from 6 V to 24 V, for example, which may cause the light emitting device to be driven unstably due to the fluctuating voltage.

Further, when the car battery is supplied with more voltage than its rated voltage, the remaining voltage used in the light emitting device is released as energy such as heat, thereby decreasing energy efficiency. In addition, due to the generation of heat, a separate heat sink should be provided within the light emitting device, and the size of the light emitting device may gradually increase due to the heat sink. As the size of the light emitting device increases, the usability of the light emitting device in a narrow space is decreased, which causes many limitations in designing the light emitting device.

### DETAILED DESCRIPTION OF INVENTION

### TECHNICAL PROBLEMS

The embodiments of the present invention are developed in the context described above, and aim to provide a light emitting device that can improve energy efficiency by controlling the number of light emitting cells.

### MEANS FOR SOLVING THE PROBLEMS

In accordance with one aspect of the present invention, there may be provided a light emitting device including: a base substrate; a plurality of light-emitting cells arranged on a surface of the base substrate and configured to emit light; a plurality of connection metal layers connecting the plurality of light-emitting cells and configured to electrically connect the plurality of light-emitting cells in series; a plurality of bump pads respectively laminated on the plurality of connection metal layers; and a control unit configured to apply current to at least some of the plurality of bump pads to cause at least one of the plurality of light-emitting cells to emit light.

Further, there may be provided the light emitting device in which the control unit is configured to apply current to at least some of the plurality of bump pads so that the plurality of light-emitting cells emit light in one of a plurality of preset light-emitting patterns, and the number of the bump pads is less than the number of the plurality of light-emitting patterns.

Further, there may be provided the light emitting device in which the bump pads have a size smaller than a size of the connection metal layers.

Further, there may be provided the light emitting device in which an area difference between the plurality of bump pads is within a range of 1% to 20% or less.

Further, there may be provided the light emitting device in which each of the plurality of bump pads is disposed within an area of two of the plurality of light-emitting cells when viewed toward the surface of the base substrate.

Further, there may be provided the light emitting device in which each of the plurality of light-emitting cells includes an N-type semiconductor layer and a P-type semiconductor layer sequentially laminated on the base substrate, and one of the plurality of connection metal layers is electrically connected at one part to the P-type semiconductor layer of one of the plurality of light-emitting cells and at another part to the N-type semiconductor layer of another of the plurality of light-emitting cells.

Further, there may be provided the light emitting device in which the plurality of light-emitting cells include a first light-emitting cell, a second light-emitting cell, and a third light-emitting cell, and the plurality of connection metal layers include: a first connection metal layer electrically connected to the first light-emitting cell; a second connection metal layer electrically connected to the first light-emitting cell and the second light-emitting cell; a third connection metal layer electrically connected to the second light-emitting cell and the third light-emitting cell; and a fourth connection metal layer electrically connected to the third light-emitting cell.

Further, there may be provided the light emitting device in which the first light-emitting cell includes a first N-type semiconductor layer and a first P-type semiconductor layer sequentially laminated on the base substrate, the second light-emitting cell includes a second N-type semiconductor layer and a second P-type semiconductor layer sequentially laminated on the base substrate, the third light-emitting cell includes a third N-type semiconductor layer and a third P-type semiconductor layer sequentially laminated on the base substrate, the first connection metal layer is electrically connected to the first P-type semiconductor layer, the second connection metal layer is electrically connected to the first N-type semiconductor layer and the second P-type semiconductor layer, the third connection metal layer is electrically connected to the second N-type semiconductor layer and the third P-type semiconductor layer, and the fourth connection metal layer is electrically connected to the third N-type semiconductor layer.

Further, there may be provided the light emitting device in which the plurality of bump pads include: a first bump pad laminated on the first connection metal layer; a second bump pad laminated on the second connection metal layer; a third bump pad laminated on the third connection metal layer; and a fourth bump pad laminated on the fourth connection metal layer, and the first bump pad, the second bump pad, the third bump pad, and the fourth bump pad are arranged sequentially clockwise with respect to a center of the base substrate when viewed toward the surface of the base substrate.

Further, there may be provided the light emitting device in which the plurality of connection metal layers are formed in different shapes from each other.

Further, there may be provided the light emitting device in which the plurality of connection metal layers reflect light emitted from the plurality of light-emitting cells toward the base substrate.

Further, there may be provided the light emitting device in which the plurality of bump pads are arranged symmetrically with respect to a center of the base substrate when the plurality of bump pads are viewed toward the surface of the base substrate.

Further, there may be provided the light emitting device in which a distance between the plurality of connection metal layers is 15 µm to 20 µm.

Further, there may be provided the light emitting device in which a convex portion is formed on one of the plurality of connection metal layers to be convex toward another one of the plurality of connection metal layers, and a concave portion is formed on the another one of the plurality of connection metal layers to be concave in a direction away from the one of the plurality of connection metal layers, and the convex portion and the concave portion are arranged to face each other.

Further, there may be provided the light emitting device in which the plurality of light-emitting cells are arranged in one direction, wherein each of the plurality of light-emitting cells further includes: an N-type semiconductor layer laminated on the base substrate; a P-type semiconductor layer laminated on the N-type semiconductor layer; an N-type electrode laminated on the N-type semiconductor layer; and a P-type electrode laminated on the P-type semiconductor layer, the plurality of connection metal layers are electrically connected to the N-type semiconductor layer and the P-type semiconductor layer through at least one of the N-type electrodes and the P-type electrodes, and the N-type electrodes of the respective light-emitting cells are arranged in the one direction, and at least one the N-type electrodes is disposed to be offset from another one in a direction perpendicular to the one direction.

Further, there may be provided a light emitting device including: a base substrate; a plurality of light-emitting cells provided on a surface of the base substrate to be spaced apart from each other and to configured to emit light; a plurality of connection metal layers respectively laminated on the plurality of light-emitting cells to be disposed within the light-emitting cells when viewed toward the surface of the base substrate and electrically connected to the plurality of light-emitting cells; a plurality of bump pads respectively laminated the plurality of connection metal layers; and a control unit configured to apply current to at least some of the plurality of bump pads to cause at least one of the plurality of light-emitting cells to emit light.

Further, there may be provided the light emitting device in which the plurality of light-emitting cells are arranged in one direction, wherein each of the plurality of light-emitting cells includes: an N-type semiconductor layer laminated on the base substrate; a P-type semiconductor layer laminated on the N-type semiconductor layer; an N-type electrode laminated on the N-type semiconductor layer; and a P-type electrode laminated on the P-type semiconductor layer, one of the plurality of connection metal layers is electrically connected to the N-type semiconductor layer through the N-type electrode, and another one of the plurality of connection metal layers is electrically connected to the P-type semiconductor layer through the P-type electrode, the surface of the base substrate is divided into a first region and a second region by an imaginary line extending from a center of the base substrate in the one direction, and the N-type electrodes of the respective light-emitting cells are arranged in the one direction, and are alternately arranged in one of the first region and the second region.

Further, there may be provided the light emitting device in which the connection metal layer electrically connected to one of the plurality of light-emitting cells is disposed within one of the plurality of light-emitting cells when viewed toward the surface of the base substrate, and the bump pad is disposed within the connection metal layer when viewed toward the surface of the base substrate.

Further, there may be provided a light emitting device including a base substrate; a first light-emitting cell provided on a surface of the base substrate; a second light-emitting cell provided on the surface of the base substrate; a plurality of connection metal layers laminated on at least one of the first light-emitting cell and the second light-emitting cell and configured to electrically connect the first light-emitting cell and the second light-emitting cell in series or in parallel ; a plurality of bump pads respectively laminated on the plurality of connection metal layers; and a control unit configured to apply current to at least some of the plurality of bump pads to cause at least one of the first light-emitting cell and the second light-emitting cell to emit light.

Further, there may be provided the light emitting device in which the plurality of connection metal layers include: a first connection metal layer electrically connected to the first light-emitting cell; a second connection metal layer electrically connected to the first light-emitting cell and the second light-emitting cell; and a third connection metal layer electrically connected to the second light-emitting cell, the first connection metal layer is disposed so that, when viewed toward the surface of the base substrate, a portion is located within the first light-emitting cell and another portion is located within the second light-emitting cell, the second connection metal layer is disposed so that, when viewed toward the surface of the base substrate, a portion is located within the first light-emitting cell and another portion is located within the second light-emitting cell, and the third connection metal layer is disposed to be located within the second light-emitting cell when viewed toward the surface of the base substrate.

### EFFECT OF INVENTION

According to the embodiments of the present invention, by controlling the number of light emitting cells and using the voltage efficiently, energy wasted as heat can be reduced, and energy efficiency can be improved.

### BRIEF DESCRIPTION OF THE DRAWINGS

FIG. 1 schematically shows a circuit diagram of a light emitting device according to a first embodiment of the present invention.
FIG. 2 is a plan view of a light emitting module of the light emitting device according to the first embodiment of the present invention.
FIG. 3 is a diagram showing one side of the light emitting module of FIG. 2.
FIG. 4 is a schematic diagram showing the circuit diagram of the light emitting module of FIG. 3.
FIG. 5 schematically shows a circuit diagram of a light emitting device according to a second embodiment of the present invention.
FIG. 6 is a plan view of a light emitting module of the light emitting device according to the second embodiment of the present invention.
FIG. 7 is a diagram showing one side of the light emitting module of FIG. 6.
FIG. 8 is a schematic diagram showing the circuit diagram of the light emitting module of FIG. 7.
FIG. 9 is a plan view of a light emitting module of the light emitting device according to a third embodiment of the present invention.
FIG. 10 is a diagram showing one side of the light emitting module of FIG. 9.
FIG. 11 is a schematic diagram showing the circuit diagram of the light emitting module of FIG. 10.
FIG. 12 is a plan view of a light emitting module of the light emitting device according to a fourth embodiment of the present invention.
FIG. 13 is a diagram showing one side of the light emitting module of FIG. 12.
FIG. 14 is a schematic diagram showing the circuit diagram of the light emitting module of FIG. 13.

### BEST MODE FOR CARRYING OUT THE INVENTION

Hereinafter, specific embodiments for implementing a spirit of the present disclosure will be described in detail with reference to the drawings.

In addition, in describing the embodiments of the present disclosure, the detailed descriptions of well-known functions or configurations will be omitted if it is determined that the detailed descriptions of well-known functions or configurations may unnecessarily make obscure the spirit of the present disclosure.

Further, when an element is referred to as being 'connected' to, 'disposed' on, or 'stacked' on another element, it should be understood that the element may be directly connected to, disposed on, or stacked on another element, but that other elements may exist in the middle.

The terms used in the present disclosure are only used for describing specific embodiments, and are not intended to limit the present disclosure. Singular expressions include plural expressions unless the context clearly indicates otherwise.

In the present specification, expressions such as upper side, lower side and the like are described based on the drawings, but it is to be noted that when the orientation of the corresponding subject is changed, it may be expressed differently. For the same reasons, some components are exaggerated, omitted, or schematically illustrated in the accompanying drawings, and the size of each component does not fully reflect the actual size.

Terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements and/or combinations thereof disclosed in the specification, and are not intended to preclude the possibility that one or more other certain features, areas, integers, steps, actions, elements and/or combinations thereof may exist or may be added.

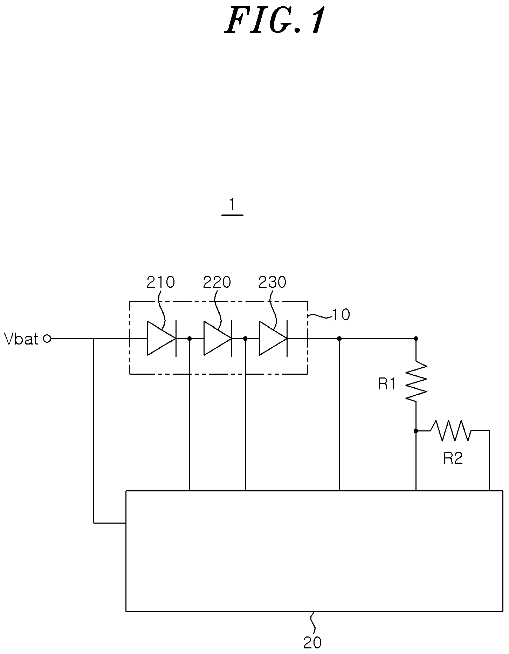

Hereinafter, a light emitting device 1 according to a first embodiment of the present disclosure will be described with reference to FIGS. 1 to 4.

Referring to FIG. 1, the light emitting device 1 according to the first embodiment of the present disclosure can emit light when receiving current from the outside. For example, the light emitting device 1 may be a vehicle light emitting device, but is not limited thereto. The light emitting device 1 may include a light emitting module 10 and a control unit 20.

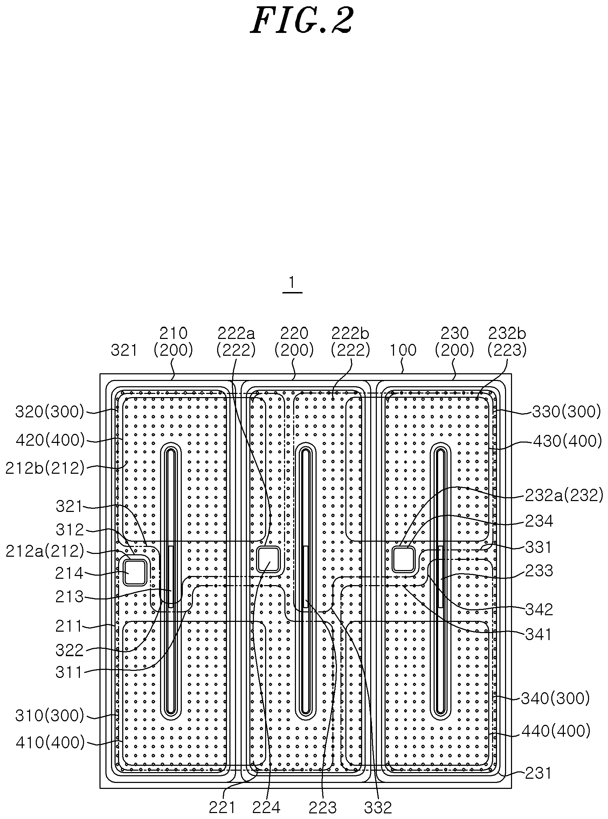

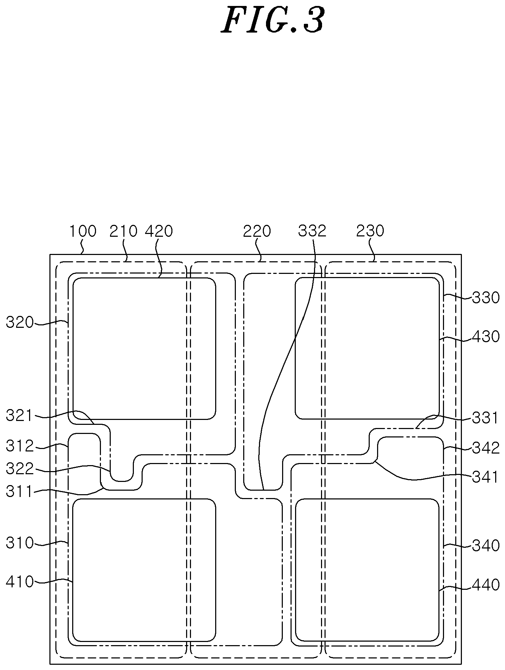

Referring further to FIGS. 2 and 3, the light emitting module 10 may be a light emitting diode. The light emitting module 10 may include a base substrate 100, a light-emitting cell 200, a connection metal layer 300, a bump pad 400 and a control unit 20.

The base substrate 100 may be an insulating or conductive substrate. The base substrate 100 may be a growth substrate for growing an N-type semiconductor layer (not shown) and P-type semiconductor layers 211, 221, 231 to be described later. In other words, the base substrate 100 may be a substrate for growing a gallium nitride-based semiconductor layer, but is not limited thereto. For example, the base substrate 100 may be a sapphire substrate, a gallium nitride substrate, a SiC substrate, etc., and may be a patterned sapphire substrate. In addition, the base substrate 100 may have a rectangular or square shape, but is not limited thereto. Further, the base substrate 100 may transmit light emitted from the light-emitting cell 200. The base substrate 100 may correspond to a transmission path through which light passes, and may function as a lens that disperses light or diffuses light internally.

A plurality of light-emitting cells 200 may be provided on a surface of the base substrate 100 to emit light. In other words, the plurality of light-emitting cells 200 may provide a light-emitting region of the light emitting device 1. The plurality of light-emitting cells 200 may be arranged in one direction on the surface of the base substrate 100, but the number, arrangement direction, and arrangement positions of the light-emitting cells 200 are not particularly limited. In addition, the plurality of light-emitting cells 200 may be arranged to be spaced apart from each other by a predetermined distance on the base substrate 100. In other words, the surface of the base substrate 100 may be exposed between the plurality of light-emitting cells 200. The plurality of light-emitting cells 200 may include a first light-emitting cell 210, a second light-emitting cell 220, and a third light-emitting cell 230.

The first light-emitting cell 210 may be provided on the surface of the base substrate 100 to emit light. The first light-emitting cell 210 may be connected in series with the second light-emitting cell 220 by the connection metal layer 300. In other words, the first light-emitting cell 210 may be electrically connected in series with the second light-emitting cell 220 by a second connection metal layer 320 to be described later.

The second light-emitting cell 220 may be provided on the surface of the base substrate 100 to emit light. The second light-emitting cell 220 may be disposed to be spaced apart from the first light-emitting cell 210, but is not limited thereto. In addition, the second light-emitting cell 220 may be connected in series with the first light-emitting cell 210 and the third light-emitting cell 230 by the connection metal layer 300. In other words, the second light-emitting cell 220 may be electrically connected in series with the third light-emitting cell 230 through a third connection metal layer 330 to be described later.

The third light-emitting cell 230 may be provided on the surface of the base substrate 100 to emit light. The third light-emitting cell 230 may be disposed to be spaced apart from the second light-emitting cell 220, but is not limited thereto. In other words, the first light-emitting cell 210, the second light-emitting cell 220, and the third light-emitting cell 230 may be arranged in one direction on the surface of the base substrate 100, but it is not limited thereto. The second light-emitting cell 220 may be disposed between the first light-emitting cell 210 and the third light-emitting cell 230. In addition, the third light-emitting cell 230 may be connected in series with the second light-emitting cell 220 through the connection metal layer 300.

In addition, the plurality of light-emitting cells 200 may be controlled by the control unit 20 to emit light in a plurality of light-emitting patterns. For example, the plurality of light-emitting patterns may include a first light-emitting pattern in which only the first light-emitting cell 210 emits light, a second light-emitting pattern in which only the second light-emitting cell 220 emits light, a third light-emitting pattern in which only the third light-emitting cell 230 emits light, a fourth light-emitting pattern in which the first light-emitting cell 210 and the second light-emitting cell 220 emit light, a fifth light-emitting pattern in which only the second light-emitting cell 220 and the third light-emitting cell 230 emit light, a sixth light-emitting pattern in which the first light-emitting cell 210 and the third light-emitting cell 230 emit light, a seventh light-emitting pattern in which all of the plurality of light-emitting cells 200 emit light, and an eighth light-emitting pattern in which none of the plurality of light-emitting cells 200 emit light. The number of such light-emitting patterns may be formed to be greater than the number of bump pads 400.

In addition, each of the plurality of light-emitting cells 200 may include an N-type semiconductor layer (not shown), P-type semiconductor layers 211, 221, 231, an active layer, first insulating layers 212, 222, 232, a second insulating layer (not shown), a conductive oxide layer (not shown), N-type electrodes 213, 223, 233, and P-type electrodes 214, 224, 234.

The N-type semiconductor layer may be provided on the surface of the base substrate 100 as a first conductive semiconductor layer. The N-type semiconductor layer may include an N-type impurity (e.g., Si, Ge, Sn). For example, the N-type semiconductor layer may include GaN or AlGaN containing Si as a dopant. The N-type semiconductor layer may be larger than the P-type semiconductor layers 211, 221, and 231. In addition, the N-type semiconductor layer may be located within an area surrounded by the edge of the base substrate 100. By the N-type semiconductor layer, a portion of the surface of the base substrate 100 may be exposed along the periphery of the N-type semiconductor layer, but the present disclosure is not limited thereto, and the edge of the N-type semiconductor layer and the edge of the base substrate 100 may be arranged in parallel. Hereinafter, the N-type semiconductor layer included in the first light-emitting cell 210 is referred to as a first N-type semiconductor layer, the N-type semiconductor layer included in the second light-emitting cell 220 is referred to as a second N-type semiconductor layer, and the N-type semiconductor layer included in the third light-emitting cell 230 is referred to as a third N-type semiconductor layer.

The P-type semiconductor layers 211, 221, 231 may be laminated on the N-type semiconductor layer as a second conductive semiconductor layer. In other words, the N-type semiconductor layer and the P-type semiconductor layers 211, 221, 231 may be sequentially laminated on the base substrate 100. The P-type semiconductor layers 211, 221, 231 may include a P-type impurity (e.g., Mg, Sr, Ba). For example, the P-type semiconductor layers 211, 221, 231 may include GaN or AlGaN containing Mg as a dopant. In addition, the conductive oxide layer or the P-type electrodes 214, 224, 234 may be laminated on the P-type semiconductor layers 211, 221, 231. Hereinafter, the P-type semiconductor layer included in the first light-emitting cell 210 is referred to as a first P-type semiconductor layer 211, the P-type semiconductor layer included in the second light-emitting cell 220 is referred to as a second P-type semiconductor layer 221, and the P-type semiconductor layer included in the third light-emitting cell 230 is referred to as a third P-type semiconductor layer 231.

The active layer may include a multiple quantum well structure (MQW), and the composition ratio of the nitride-based semiconductor can be adjusted to emit light of a desired wavelength. For example, the active layer may emit blue light or ultraviolet light depending on the semiconductor material and its composition ratio. The active layer may be located between the N-type semiconductor layer and the P-type semiconductor layers 211, 221, 231. Hereinafter, the active layer included in the first light-emitting cell 210 is referred to as a first active layer, the active layer included in the second light-emitting cell 220 is referred to as a second active layer, and the active layer included in the third light-emitting cell 230 is referred to as a third active layer.

The N-type semiconductor layer, the P-type semiconductor layers 211, 221, 231 and the active layer may include a III-V series nitride-based semiconductor, and for example, may include a nitride-based semiconductor such as Al, Ga, In, etc.

The conductive oxide layer may be laminated on the P-type semiconductor layers 211, 221, 231. The conductive oxide layer is not necessarily required. In other words, the P-type electrodes 214, 224, 234 may be directly laminated on the P-type semiconductor layers 211, 221, 231. The conductive oxide layer may be formed as an oxide layer that transmits light generated in the active layer. For example, the conductive oxide layer may be formed of ITO or ZnO. Hereinafter, the conductive oxide layer included in the first light-emitting cell 210 is referred to as a first conductive oxide layer, the conductive oxide layer included in the second light-emitting cell 220 is referred to as a second conductive oxide layer, and the conductive oxide layer included in the third light-emitting cell 230 is referred to as a third conductive oxide layer.

The first insulating layers 212, 222, 232 may at least partially cover the conductive oxide layer. The first insulating layers 212, 222, 232 may cover side surfaces of the P-type semiconductor layers 211, 221, 231 and the active layer. In addition, the first insulating layers 212, 222, 232 may be covered by the second insulating layer. In other words, the edge of the first insulating layers 212, 222, 232 may be located farther from the edge of the base substrate 100 than the edge of the second insulating layer. Further, the edge of the first insulating layers 212, 222, 232 may be in contact with the N-type semiconductor layer. In addition, a plurality of openings may be formed in the first insulating layers 212, 222, 232. Through the plurality of openings, the P-type semiconductor layers 211, 221, 231 can be electrically connected to the outside. The plurality of openings formed in the first insulating layers 212, 222, 232 may be formed with different sizes. The plurality of openings may include first openings 212a, 222a, 232a and second openings 212b, 222b, 232b.

The first openings 211a, 222a, 232a may be formed larger than the second openings 212b, 222b, 232b. Each of the plurality of light-emitting cells 200 may be provided with one first opening 211a, 222a, 232a, but it is not limited thereto. Through the first openings 211a, 222a, 232a, current is quickly and evenly transmitted to the P-type semiconductor layers 211, 221, 231, and more light is generated in the active layer, so that the light efficiency can be increased.

The second openings 212b, 222b, 232b may be smaller than the first openings 211a, 222a, 232a. In addition, the second openings 212b, 222b, 232b may be provided in plural, but it is not limited thereto. Current may be transmitted to the P-type semiconductor layers 211, 221, 231 through the second openings 212b, 222b, 232b.

Hereinafter, the first insulating layer included in the first light-emitting cell 210 is referred to as a first light-emitting insulating layer 212, the first insulating layer included in the second light-emitting cell 220 is referred to as a second light-emitting insulating layer 222, and the first insulating layer included in the third light-emitting cell 230 is referred to as a third light-emitting insulating layer 232.

The second insulating layer may cover the first insulating layers 212, 222, 232. In addition, the second insulating layer may be laminated on the P-type electrodes 214, 224, 234 to cover a portion of the P-type electrodes 214, 224, 234. Hereinafter, the second insulating layer included in the first light-emitting cell 210 is referred to as a first cover insulating layer, the second insulating layer included in the second light-emitting cell 220 is referred to as a second cover insulating layer, and the second insulating layer included in the third light-emitting cell 230 is referred to as a third cover insulating layer.

The N-type electrodes 213, 223, 233 may be laminated on the N-type semiconductor layer and may be electrically connected to the N-type semiconductor layer. The N-type electrodes 213, 223, 233 may be disposed in a via region of the light-emitting cell 200. In addition, the N-type electrodes 213, 223, 233 may be arranged in one direction when viewed in a direction toward the surface of the base substrate 100. Further, at least one of the N-type electrodes 213, 223, 233 may be offset from another one in a direction perpendicular to the one direction. In addition, a plurality of N-type electrodes 213, 223, 233 and a plurality of first openings 211a, 222a, 232a are arranged alternately in one direction when viewed in the direction toward the surface of the base substrate 100, but at least one of them may be offset from the other in a direction perpendicular to the one direction.

Hereinafter, the N-type electrode included in the first light-emitting cell 210 is referred to as a first N-type electrode 213, the N-type electrode included in the second light-emitting cell 220 is referred to as a second N-type electrode 223, and the N-type electrode included in the third light-emitting cell 230 is referred to as a third N-type electrode 233.

The P-type electrodes 214, 224, 234 may be laminated on the P-type semiconductor layers 211, 221, 231 or the conductive oxide layer and electrically connected thereto. Current can be applied to the P-type semiconductor layers 211, 221, 231 through the P-type electrodes 214, 224, 234. Hereinafter, the P-type electrode included in the first light-emitting cell 210 is referred to as a first P-type electrode 214, the P-type electrode included in the second light-emitting cell 220 is referred to as a second P-type electrode 224, and the P-type electrode included in the third light-emitting cell 230 is referred to as a third P-type electrode 234.

A plurality of connection metal layer 300 may be formed, and may be connected to the plurality of light-emitting cells 200 so that the plurality of light-emitting cells 200 are electrically connected in series. In other words, one of the plurality of connection metal layers 300 may be electrically connected to one part to the P-type semiconductor layers 211, 221, 231 of one of the plurality of light-emitting cells 200 and to another part to the N-type semiconductor layer of another one of the plurality of light-emitting cells 200. The plurality of connection metal layers 300 may be formed in different shapes. The plurality of connection metal layers 300 can reflect light emitted from the plurality of light-emitting cells toward the base substrate 100. In addition, the spacing between the plurality of connection metal layers 300 may be 15 µm to 20 µm.

Further, each of the plurality of connection metal layers 300 may be formed with one or more concave portions 311, 321, 331, 341 and one or more convex portions 312, 322, 332, 342. The convex portions 312, 322, 332, 342 may be formed convexly from one of the plurality of connection metal layers 300 toward another one of the plurality of connection metal layers 300. In addition, the concave portions 311, 321, 331, 341 of one of the plurality of connection metal layers 300 may be formed concavely in a direction away from another one of the plurality of connection metal layers 300. Further, the convex portions 312, 322, 332, 342 of one of the plurality of connection metal layers 300 and the concave portions 311, 321, 331, 341 of another one of the plurality of connection metal layers 300 may be arranged to face each other.

The connection metal layer 300 may include a first connection metal layer 310, a second connection metal layer 320, a third connection metal layer 330, and a fourth connection metal layer 340.

The first connection metal layer 310 may be electrically connected to the first light-emitting cell 210. In other words, the first connection metal layer 310 may be electrically connected to at least one of the first P-type semiconductor layer 211 and the first conductive oxide layer through the first P-type electrode 214. When current is supplied to the first connection metal layer 310, the current can be supplied to the first P-type semiconductor layer 211 through the first P-type electrode 214. In other words, the current can sequentially flow through the first P-type semiconductor layer 211, the first active layer, and the first N-type semiconductor layer of the first light-emitting cell 210 and then can be supplied to the second connection metal layer 320 through the first N-type electrode 213.

The first connection metal layer 310 may be disposed within at least a partial region of the first light-emitting cell 210 and the second light-emitting cell 220 when viewed toward the surface of the base substrate 100. In other words, when viewed toward the surface of the base substrate 100, a portion of the first connection metal layer 310 may be disposed within the first P-type semiconductor layer 211 and another portion thereof may be disposed within the second P-type semiconductor layer 221. In addition, one or more first concave portions 311 and one or more first convex portions 312 may be formed in the first connection metal layer 310.

A plurality of first concave portions 311 may be formed and may be formed concavely in a direction away from at least one of the second connection metal layer 320 and the third connection metal layer 330. One of the plurality of first concave portions 311 may be disposed to face the second convex portion 322 to be described later, and another one of the plurality of first concave portions 311 may be disposed to face the third convex portion 332 to be described later.

The first convex portions 312 may be formed convexly toward at least one of the second connection metal layer 320 and the fourth connection metal layer 340. One of the plurality of first convex portions 312 may be disposed to face the second concave portion 321 to be described later. In addition, when viewed toward the surface of the base substrate 100, the first P-type electrode 214 may be disposed within the first convex portion 312.

The second connection metal layer 320 may be electrically connected to the first light-emitting cell 210 and the second light-emitting cell 220. The first light-emitting cell 210 and the second light-emitting cell 220 are connected in series by the second connection metal layer 320, so that when current is supplied to the first light-emitting cell 210, the current can be supplied to the second light-emitting cell 220. In other words, the second connection metal layer 320 may be electrically connected to the first N-type semiconductor layer through the first N-type electrode 213 and electrically connected to the second P-type semiconductor layer 221 through the second P-type electrode 224. When current is supplied to the second connection metal layer 320, the current can sequentially flow through the second P-type semiconductor layer 221, the second active layer, and the second N-type semiconductor layer of the second light-emitting cell 220 and then can be supplied to the third connection metal layer 330 through the second N-type electrode 223.

The second connection metal layer 320 may be arranged within at least a partial region of the first light-emitting cell 210 and the second light-emitting cell 220 when viewed toward the surface of the base substrate 100. In other words, when viewed toward the surface of the base substrate 100, a portion of the second connection metal layer 320 may be disposed within the first P-type semiconductor layer 211 and another portion thereof may be disposed within the second P-type semiconductor layer 221. In addition, one or more second concave portions 321 and one or more second convex portions 322 may be formed in the second connection metal layer 320.

The second concave portion 321 may be formed concavely in a direction away from the first connection metal layer 310.

The second convex portion 322 may be formed convexly toward the first connection metal layer 310. The second convex portion 322 may be disposed to face the first concave portion 311. In other words, the second convex portion 322 may be located on the inner side of the first concave portion 311. In addition, when viewed toward the surface of the base substrate 100, the first N-type electrode 213 may be disposed within the second convex portion 322.

The third connection metal layer 330 can electrically connect the second light-emitting cell 220 and the third light-emitting cell 230. The second light-emitting cell 220 and the third light-emitting cell 230 are connected in series by the third connection metal layer 330, so that when current is supplied to the second light-emitting cell 220, the current can be supplied to the third light-emitting cell 230. In other words, the third connection metal layer 330 may be electrically connected to the second N-type semiconductor layer through the second N-type electrode 223 and electrically connected to the third P-type semiconductor layer 231 through the third P-type electrode 234. When current is supplied to the third connection metal layer 330, the current can sequentially flow through the third P-type semiconductor layer 231, the third active layer, and the third N-type semiconductor layer of the third light-emitting cell 230 and then can be supplied to the fourth connection metal layer 340 through the third N-type electrode 233.

In addition, the third connection metal layer 330 may be disposed within at least a partial region of the second light-emitting cell 220 and the third light-emitting cell 230 when viewed toward the surface of the base substrate 100. In other words, when viewed toward the surface of the base substrate 100, a portion of the third connection metal layer 330 may be disposed within the second P-type semiconductor layer 221 and another portion thereof may be disposed within the third P-type semiconductor layer 231.

In addition, one or more third concave portions 331 and one or more third convex portions 332 may be formed in the third connection metal layer 330.

The third concave portion 331 may be formed concavely in a direction away from the fourth connection metal layer 340.

The third convex portion 332 may be formed convexly toward the first connection metal layer 310. In addition, when viewed toward the surface of the base substrate 100, the second N-type electrode 223 may be disposed within the third convex portion 332.

The fourth connection metal layer 340 may be electrically connected to the third light-emitting cell 230. The fourth connection metal layer 340 may be electrically connected to the third N-type semiconductor layer through the third N-type electrode 233. In addition, the fourth connection metal layer 340 may be disposed within at least a partial region of the second light-emitting cell 220 and the third light-emitting cell 230 when viewed toward the surface of the base substrate 100. In other words, when viewed toward the surface of the base substrate 100, a portion of the fourth connection metal layer 340 may be disposed within the second P-type semiconductor layer 221 and another portion thereof may be disposed within the third P-type semiconductor layer 231.

In addition, one or more fourth concave portions 341 and one or more fourth convex portions 342 may be formed in the fourth connection metal layer 340.

The fourth concave portion 341 may be formed concavely in a direction away from the third connection metal layer 330.

The fourth convex portion 342 may be formed convexly toward the third connection metal layer 330. In addition, when viewed toward the surface of the base substrate 100, the third N-type electrode 233 may be disposed within the fourth convex portion 342.

By the plurality of connection metal layers 300, when current is supplied to the first light-emitting cell 210, the current can be transferred to the second light-emitting cell 220, and then the current can be transferred from the second light-emitting cell 220 to the third light-emitting cell 230.

A plurality of bump pads 400 may be formed and may be laminated on the respective connection metal layers 300. The size of the bump pad 400 may be smaller than the size of the connection metal layer 300. In other words, the bump pad 400 may be disposed within the connection metal layer 300 when viewed toward the surface of the base substrate 100. In addition, the area difference between the plurality of bump pads 400 may be within a range of 1% to 20% or less. Each of the bump pads 400 may be disposed within an area of two of the plurality of light-emitting cells 200 when viewed toward the surface of the base substrate 100. The plurality of bump pads 400 may include a first bump pad 410, a second bump pad 420, a third bump pad 430, and a fourth bump pad 440. Meanwhile, the first bump pad 410, the second bump pad 420, the third bump pad 430, and the fourth bump pad 440 are exposed on one side of the light emitting device 1, so that the light emitting device 1 can be electrically connected to a printed circuit board (PCB) through the bump pads.

The first bump pad 410 may be laminated on the first connection metal layer 310. The first bump pad 410 may be disposed within the first light-emitting cell 210 and the second light-emitting cell 220 when viewed toward the surface of the base substrate 100.

The second bump pad 420 may be laminated on the second connection metal layer 320. The second bump pad 420 may be disposed within the area of the first light-emitting cell 210 and the second light-emitting cell 220 when viewed toward the surface of the base substrate 100.

The third bump pad 430 may be laminated on the third connection metal layer 330. The third bump pad 430 may be disposed within an area of the second light-emitting cell 220 and the third light-emitting cell 230 when viewed toward the surface of the base substrate 100.

The fourth bump pad 440 may be laminated on the fourth connection metal layer 340. The fourth bump pad 440 may be disposed within the area of the second light-emitting cell 220 and the third light-emitting cell 230 when viewed toward the surface of the base substrate 100.

The first bump pad 410, the second bump pad 420, the third bump pad 430, and the fourth bump pad 440 may be sequentially arranged clockwise with respect to the center of the base substrate 100 when viewed toward the surface of the base substrate 100. In addition, the first bump pad 410, the second bump pad 420, the third bump pad 430, and the fourth bump pad 440 may be arranged symmetrically with respect to the center of the base substrate 100. For example, when the surface of the base substrate 100 is divided into four quadrants, the plurality of bump pads 400 may be arranged one in each quadrant so that their positions are symmetrical with respect to each other.

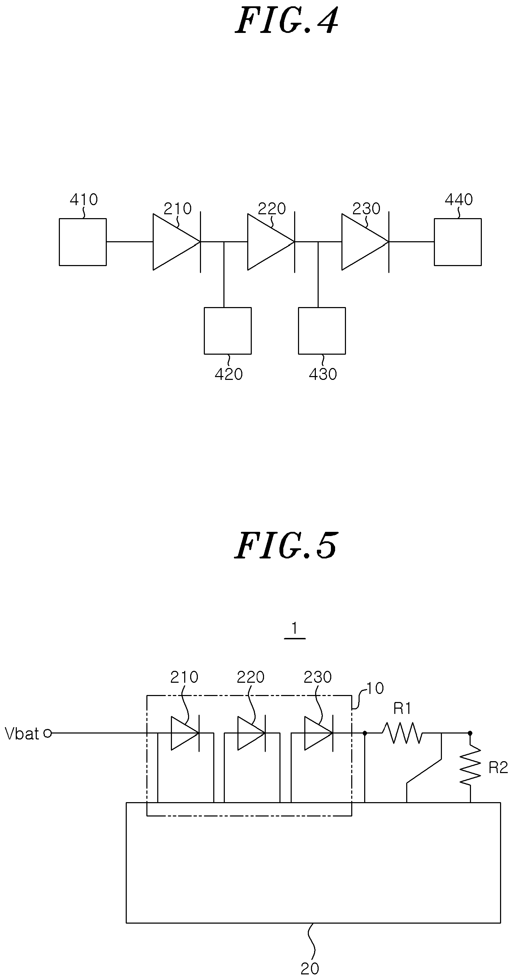

Referring further to FIG. 4, the plurality of bump pads 400 can be used to measure whether the plurality of light-emitting cells 200 are operating properly. For example, by electrically connecting the first bump pad 410 and the second bump pad 420, it is possible to measure whether the first light-emitting cell 210 is emitting light properly. In addition, by electrically connecting the second bump pad 420 and the third bump pad 430, it is possible to measure whether the second light-emitting cell 220 is emitting light properly. Further, by electrically connecting the third bump pad 430 and the fourth bump pad 440, it is possible to measure whether the third light-emitting cell 230 is emitting light properly. For example, when the light emitting module 10 emits light at a lower brightness than a target brightness, some of the plurality of bump pads 400 can be electrically connected to easily determine which of the plurality of light emitting cells 200 has a problem.

By connecting the first bump pad 410 and the second bump pad 420 in series, only the first light-emitting cell 210 can be made to emit light. By connecting the first bump pad 410 and the third bump pad 430 in series, the first light-emitting cell 210 and the second light-emitting cell 220 can be made to emit light. In addition, by connecting the first bump pad 410 and the fourth bump pad 440 in series, all of the plurality of light-emitting cells 200 can be made to emit light.

The control unit 20 may apply current to at least some of the plurality of bump pads 400 to cause one or more of the plurality of light-emitting cells 200 to emit light. For example, the control unit 20 may be an integrated circuit (IC). In addition, the control unit 20 may cause one or more of the plurality of light-emitting cells 200 to emit light based on a plurality of light-emitting patterns.

As a first example, the control unit 20 may supply current to the first bump pad 410 and the second bump pad 420 based on the first light-emitting pattern. When current is supplied to the first bump pad 410 and the second bump pad 420 by the control unit 20, the first bump pad 410 and the second bump pad 420 are connected in series so that only the first light-emitting cell 210 can emit light. When only the first light-emitting cell 210 emits light by the control unit 20, a voltage of 3 V can be applied to the first light-emitting cell 210.

As a second example, the control unit 20 may supply current to the first bump pad 410 and the third bump pad 430 based on the fourth light-emitting pattern. When current is supplied to the first bump pad 410 and the third bump pad 430 by the control unit 20, the first bump pad 410 and the third bump pad 430 are connected in series so that the first light-emitting cell 210 and the second light-emitting cell 220 can emit light. When the first light-emitting cell 210 and the second light-emitting cell 220 emit light by the control unit 20, a voltage of 6 V can be applied to the first light-emitting cell 210 and the second light-emitting cell 220.

As a third example, the control unit 20 may supply current to the first bump pad 410 and the fourth bump pad 440 based on the seventh light-emitting pattern. When current is supplied to the first bump pad 410 and the fourth bump pad 440 by the control unit 20, the first bump pad 410 and the fourth bump pad 440 are connected in series so that the first light-emitting cell 210, the second light-emitting cell 220, and the third light-emitting cell 230 can all emit light. When the first light-emitting cell 210, the second light-emitting cell 220, and the third light-emitting cell 230 all emit light by the control unit 20, a voltage of 9 V can be applied to the first light-emitting cell 210, the second light-emitting cell 220, and the third light-emitting cell 230.

In other words, the control unit 20 can selectively activate the plurality of light-emitting cells 200 at one of 3 V, 6 V, and 9 V.

Hereinafter, the operation and effects of the light emitting device 1 according to the first embodiment of the present disclosure will be described.

The light emitting device 1 according to the first embodiment of the present disclosure can be utilized in all devices that perform linear drive. For example, it can be applied to all devices capable of performing linear switching drive including a linear circuit, and utilized for linear drive optimization. Depending on the voltage provided by the linear driving device, each light-emitting cell 200 can be selectively and individually driven to maximize the voltage utilization. Specifically, it can be utilized in linear driving based on an automobile battery to efficiently use energy. More specifically, it can be used for automobile interior lighting supplied with a voltage Vbat of about 12 V of a car battery. The voltage Vbat of the car battery that supplies about 12 V may have a fluctuation specification of about 6 V to 12 V or more due to various factors. For example, when the voltage Vbat of the car battery is about 7 V, the light emitting device 1 of the present disclosure can activate only the first light-emitting cell 210 and the second light-emitting cell 220 and individually drive the light-emitting cells 200 according to the supplied voltage. In addition, when the voltage Vbat of the car battery is about 9 V or higher, all of the light-emitting cells 200 can be driven. Therefore, even if the range of the voltage Vbat provided from the car battery varies due to external factors, the plurality of light-emitting cells 200 can be selectively driven according to the supplied voltage, so that the voltage Vbat supplied from the car battery can be utilized as efficiently as possible.

Further, since the light emitting device 1 can include a plurality of light-emitting cells, it can be more suitable for efficiently using the provided battery voltage Vbat compared to a light emitting diode composed of a single light-emitting cell. For example, when using a light emitting diode composed of a single light-emitting cell in a car battery that provides about 12 V of voltage, only about 3 V is used, so the remaining voltage except for about 3 V from the provided battery voltage Vbat of about 12 V is not utilized and is released as heat, which reduces energy usage efficiency. In addition, since a lot of heat is released, the size of the heat sink may need to be increased, which may impose limitations on achieving a compact light emitting device. However, when using the light emitting device 1 that includes the plurality of light-emitting cells 200, about 9 V can be used from the provided battery voltage Vbat of about 12 V, which effectively reduces energy wasted as heat.

In addition, the operation of the light-emitting cells can be selectively controlled according to the voltage Vbat supplied from the car battery. For example, when only a voltage of about 3 V is supplied, the control unit 20 can supply current only to the first bump pad 410 and the second bump pad 420 to drive only the first light-emitting cell 210. Therefore, only about 3 V supplied from the car battery can be used. When a voltage lower than the voltage Vbat required to drive two light-emitting cells 200 is supplied from the car battery, the control unit 20 can control only one light-emitting cell 200 to be driven. Therefore, energy efficiency can be improved by maximizing the utilization of the voltage Vbat supplied from the battery.

As another example, when the voltage supplied from the car battery is about 6 V, the control unit 20 can supply current only to the first bump pad 410 and the third bump pad 430 to allow the first light-emitting cell 210 and the second light-emitting cell 220 to be driven. In other words, when the voltage Vbat supplied from the car battery is lower than the voltage required to drive three light-emitting cells, the control unit 20 can control only two light-emitting cells 200 to be driven. Meanwhile, the remaining voltage after driving the light-emitting cells 200 can be dissipated through a first resistor R1, or the first resistor R1 and a second resistor R2.

In addition, if the voltage Vbat supplied from the car battery can drive all of the plurality of light-emitting cells 200, the control unit 20 can supply current to the first bump pad 410 and the fourth bump pad 440 to allow all of the plurality of light-emitting cells 200 to be driven. In this way, by selectively driving the light-emitting cells 200 according to the supplied voltage, the energy wasted as heat can be minimized by maximizing the use of the voltage supplied from the car battery, which improves energy usage efficiency.

The utilization of the vehicle light emitting device can be applied to, for example, vehicle interior lighting and vehicle displays. More specifically, it can be suitable for use in a head-up display (HUD). The head-up display is a device that virtually visualizes information required by a driver, such as current vehicle speed, remaining fuel, and navigation guidance information, and projects it onto a windshield within the driver's field of view, thereby minimizing the driver's unnecessary gaze shift to other places and enhancing driving safety. The head-up display utilizes the principle that light from a light emitting device passes through a TFT (Thin Film Transistor) projection display and is reflected by a mirror to form an image on the windshield within the driver's field of view.

To ensure that light reflected by the mirror forms a clear and uniform image on the windshield, the brightness of the light emitted from the light emitting device needs to be maintained high. Therefore, the voltage supplied from the car battery should be used without wasting it, so that the light emitting diode can emit light with high brightness. Since the light emitting device 1 provided in the present disclosure can provide a high-brightness, high-efficiency light emitting device can be implemented by selectively driving the light-emitting cells 200 so that the voltage supplied from the car battery can be used to the maximum extent to efficiently use the voltage. In addition, as compared to a light emitting diode having one light-emitting cell, it can emit light with high brightness by activating a plurality of light-emitting cells 200. Therefore, when applied to the head-up display, it can emit high-brightness light so that the image projected on the transparent front windshield of a car can be implemented more clearly and uniformly to provide accurate information, which allows the driver to see the information necessary for driving at a glance.

In addition, by applying a high-voltage driven light emitting diode including a plurality of light-emitting cells 200, it is possible to maintain the same level of brightness while supplying a lower current as compared to a light emitting diode including only one light-emitting cell. Therefore, depending on the voltage supplied from the car battery, the number of driven light-emitting cells 200 is selectively controlled, and the intensity of the current is adjusted according to the driven light-emitting cells 200, so that an equivalent level of brightness can be supplied regardless of the number of light-emitting cells 200 that emit light. This provides the effect of keeping the brightness of light emitted from the light emitting device 1 uniform.

In addition, by supplying low current, the power load applied to a drive channel can be effectively reduced, thereby preventing excessive heat generation in the light emitting device 1. Accordingly, the light emitting device 1 may obviate the need for a separate heat sink, which allows a miniaturized light emitting device. The miniaturization of the product enables a design that is free from spatial constraints, and improves its applicability in narrow spaces.

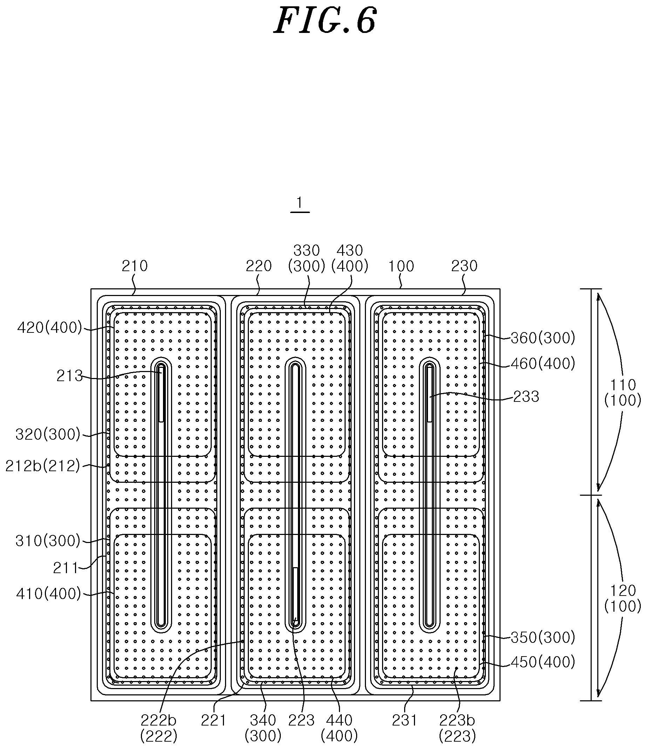

Hereinafter, a light emitting device 1 according to a second embodiment of the present disclosure will be described with reference to FIGS. 5 to 8.

In describing the second embodiment, there is a difference in that at least some of the plurality of light-emitting cells 200 can be connected in parallel, and this difference will be mainly described. Unlike the first embodiment of the present disclosure, the plurality of light-emitting cells 200 in the second embodiment may not be electrically connected to each other. In other words, the plurality of light-emitting cells 200 are not connected through the connection metal layer 300. Further, the plurality of connection metal layers 300 of the second embodiment may further include a fifth connection metal layer 350 and a sixth connection metal layer 360. In addition, the plurality of bump pads 400 of the second embodiment may further include a fifth bump pad 450 and a sixth bump pad 460.

The surface of the base substrate 100 may be divided into a first region 110 and a second region 120 based on an imaginary line passing through the center of the surface while extending in one direction.

The plurality of light-emitting cells 200 may be arranged at a predetermined interval in one direction on the base substrate 100, but the present disclosure is not limited thereto, and the plurality of light-emitting cells 200 may respectively be arranged on substrates spaced apart from each other. In addition, the plurality of light-emitting cells 200 may have a structurally identical shape, but the present disclosure is not limited thereto, and the plurality of light-emitting cells 200 may be formed in different shapes.

The second light-emitting cell 220 may be disposed at a predetermined distance from the first light-emitting cell 210. The third light-emitting cell 230 may be disposed at a predetermined distance from the second light-emitting cell 220. In other words, the second light-emitting cell 220 may be disposed between the first light-emitting cell 210 and the third light-emitting cell 230.

The N-type electrodes 213, 223, 233 of the respective light-emitting cells 200 may be arranged in one direction when viewed toward the surface of the base substrate 100, but may be arranged alternately in the first region 110 and the second region 120. For example, the first N-type electrode 213 may be disposed in the first region 110, the second N-type electrode 223 may be disposed in the second region, and the third N-type electrode 233 may be disposed in the first region 110.

The plurality of connection metal layers 300 may be formed in the same shape, but may be formed in different shapes without being limited thereto.

The first connection metal layer 310 may be positioned within the second region 120 of the base substrate 100 when viewed toward the surface of the base substrate 100. The first connection metal layer 310 may be positioned within the first light-emitting cell 210 when viewed toward the surface of the base substrate 100. The first connection metal layer 300 may be electrically connected to the first P-type semiconductor layer 211 through the first P-type electrode 214.

The second connection metal layer 320 may be positioned within the first region 110 of the base substrate 100 when viewed toward the surface of the base substrate 100. In addition, the second connection metal layer 320 may be positioned within the first light-emitting cell 210 when viewed toward the surface of the base substrate 100. The second connection metal layer 320 may be electrically connected to the first N-type semiconductor layer through the first N-type electrode 213.

The third connection metal layer 330 may be positioned within the first region 110 of the base substrate 100 when viewed toward the surface of the base substrate 100. In addition, the third connection metal layer 320 may be positioned within the second light-emitting cell 220 when viewed toward the surface of the base substrate 100. The third connection metal layer 330 may be electrically connected to the second P-type semiconductor layer 221 through the second P-type electrode 224.

The fourth connection metal layer 340 may be positioned within the second region 120 of the base substrate 100 when viewed toward the surface of the base substrate 100. In addition, the fourth connection metal layer 340 may be positioned within the second light-emitting cell 220 when viewed toward the surface of the base substrate 100. The fourth connection metal layer 330 may be electrically connected to the second N-type semiconductor layer through the second N-type electrode 223.

The fifth connection metal layer 350 may be positioned within the second region 120 of the base substrate 100 when viewed toward the surface of the base substrate 100. In addition, the fifth connection metal layer 350 may be positioned within the third light-emitting cell 230 when viewed toward the surface of the base substrate 100. The fifth connection metal layer 330 may be electrically connected to the third P-type semiconductor layer 231 through the third P-type electrode 234.

The sixth connection metal layer 360 may be positioned within the first region 110 of the base substrate 100 when viewed toward the surface of the base substrate 100. In addition, the sixth connection metal layer 360 may be positioned within the third light-emitting cell 230 when viewed toward the surface of the base substrate 100. The sixth connection metal layer 360 may be electrically connected to the third N-type semiconductor layer through the third N-type electrode 233.

The plurality of bump pads 400 may be formed in the same shape, but may be formed in different shapes without being limited thereto. In addition, the bump pad 400 may be disposed within the connection metal layer 300 when viewed toward the surface of the base substrate 100.

The first bump pad 410 may be laminated on the first connection metal layer 310 to be positioned in the second region 120 when viewed toward the surface of the base substrate 100.

The second bump pad 420 may be laminated on the second connection metal layer 320 to be positioned in the first region 110 when viewed toward the surface of the base substrate 100. When current is applied to the first bump pad 410, the current may be transmitted to the second bump pad 420 through the first connection metal layer 310, the first P-type semiconductor layer 211, the first N-type semiconductor layer, and the second connection metal layer 320. When current is applied to the first bump pad 410 and the second bump pad 420, the first light-emitting cell 210 can emit light.

The third bump pad 430 may be laminated on the third connection metal layer 330 to be positioned in the first region 110 when viewed toward the surface of the base substrate 100.

The fourth bump pad 440 may be laminated on the fourth connection metal layer 340 to be positioned in the second region 120 when viewed toward the surface of the base substrate 100. When current is applied to the third bump pad 430, the current may be transmitted to the fourth bump pad 440 through the third connection metal layer 330, the second P-type semiconductor layer 221, the second N-type semiconductor layer, and the fourth connection metal layer 340. When current is applied to the third bump pad 430 and the fourth bump pad 440, the second light-emitting cell 220 can emit light.

The fifth bump pad 450 may be laminated on the fifth connection metal layer 310 to be positioned in the second region 120 when viewed toward the surface of the base substrate 100.

The sixth bump pad 460 may be laminated on the sixth connection metal layer 360 to be positioned in the first region 110 when viewed toward the surface of the base substrate 100. When current is applied to the fifth bump pad 450, the current may be transmitted to the sixth bump pad 460 through the fifth connection metal layer 310, the third P-type semiconductor layer 231, the third N-type semiconductor layer, and the sixth connection metal layer 360. When current is applied to the fifth bump pad 450 and the sixth bump pad 460, the third light-emitting cell 230 can emit light.

Meanwhile, although the second embodiment has been described that all of the plurality of light-emitting cells 200 are connected in parallel, but the present disclosure is not limited thereto, and only some of the plurality of light-emitting cells 200 may be connected in parallel.

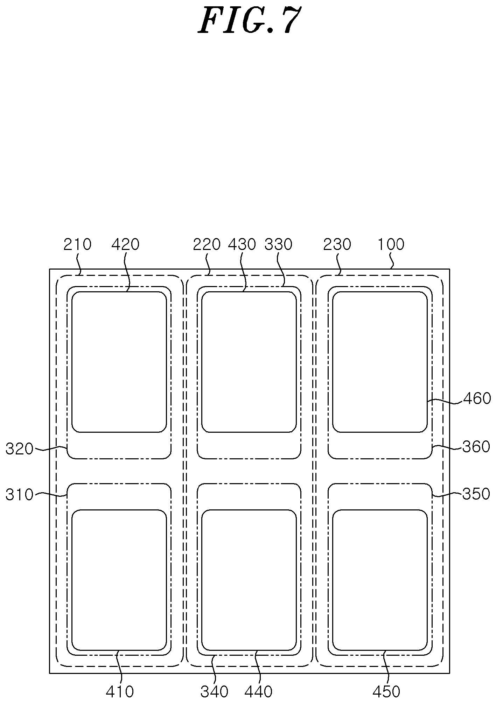

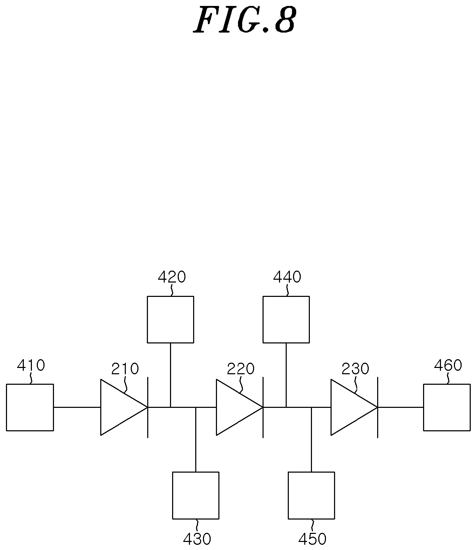

FIG. 7 is a diagram showing one side where the plurality of bump pads 400 are exposed, and FIG. 8 is a circuit diagram showing electrical connections between the plurality of light-emitting cells 200 connected in series and the plurality of bump pads 400.

Referring to FIGS. 7 and 8, the plurality of bump pads 400 can be used to measure whether the plurality of light-emitting cells 200 are operating properly. By electrically connecting the first bump pad 410 and the second bump pad 400, it is possible to measure whether the first light-emitting cell 210 is emitting light properly. In addition, by electrically connecting the third bump pad 430 and the fourth bump pad 440, it is possible to measure whether the second light-emitting cell 220 is emitting light properly. By electrically connecting the fifth bump pad 450 and the sixth bump pad 460, it is possible to measure whether the third light-emitting cell 230 is emitting light properly. Therefore, when the light emitting device 1 is not properly operated and the light emitting module 10 emits light at a low brightness, it is easy to determine which light-emitting cell among the plurality of light-emitting cells 200 has a problem.

The control unit 20 may connect at least two or more of the plurality of light-emitting cells 200 in parallel. In other words, the control unit 20 can operate so that at least two or more of the plurality of light-emitting cells 200 are connected in series or in parallel. For example, the control unit 20 may connect the first light-emitting cell 210 and the second light-emitting cell 220 in series, and connect the second light-emitting cell 220 and the third light-emitting cell 230 in parallel. In addition, the control unit 20 may connect all of the plurality of light-emitting cells 200 in parallel.

Hereinafter, the operation and effects of the light emitting device 1 according to the second embodiment of the present disclosure will be described.

At least some of the plurality of light-emitting cells 200 of the light emitting device 1 according to the second embodiment of the present disclosure may be connected in parallel. When at least some of the plurality of light-emitting cells 200 are connected in parallel, for example, when a voltage Vbat of about 6 V is supplied from the car battery of about 12 V, the three light-emitting cells can be driven to emit light at about 6 V while supplying a low current. In other words, in case that the light-emitting cells are connected only in series, when the voltage Vbat of about 6 V is supplied from the car battery, two light-emitting cells 200 can be driven to emit light to optimize the voltage usage. However, when the light-emitting cells 200 are connected in parallel, it becomes possible to activate all the plurality of light-emitting cells 200 using low current, ensuring that the voltage Vbat of about 6 V of the car battery can be used without waste. Therefore, it is possible to maintain the brightness of the light emitting device 1 while supplying low current. Operating at low current can effectively reduce the thermal resistance generated inside the light emitting device 1, so that a heat dissipation effect can be provided without using a separate heat sink. In addition, since no separate heat sink is used, it is possible to implement miniaturization of the light emitting device. Therefore, the light emitting device 1 can be applied without spatial limitations, which makes design of the light emitting device 1 flexible.

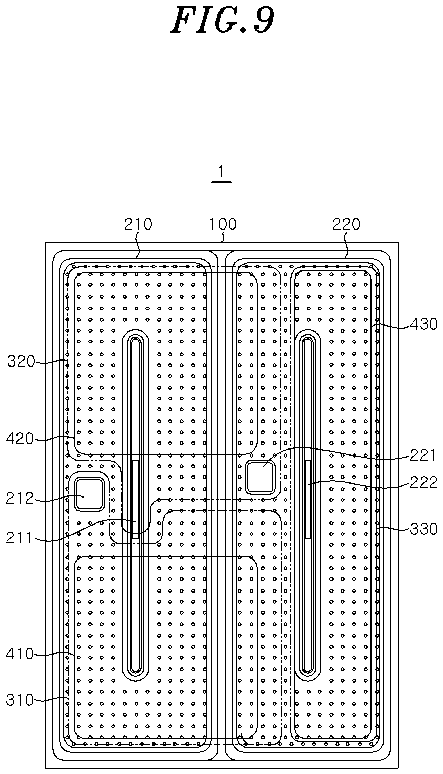

Hereinafter, with reference to FIGS. 9 to 11, a light emitting device 1 according to a third embodiment of the present disclosure will be described. The light emitting device 1 according to the third embodiment of the present disclosure may include a first light-emitting cell 210 and a second light-emitting cell 220. The first light-emitting cell 210 and the second light-emitting cell 220 may be disposed to be spaced apart from each other on the same base substrate 100. In addition, the first light-emitting cell 210 and the second light-emitting cell 220 may be connected in series to each other through a second connection metal layer 300. The structure and shape of the first light-emitting cell 210 and the second light-emitting cell 220 are the same as those of the first embodiment described above, and detailed descriptions thereof will be omitted. Further, the first connection metal layer 310, the second connection metal layer 320, the first bump pad 410 and the second bump pad 420 are the same as those in the first embodiment described above.

The third connection metal layer 330 may be disposed within the second light-emitting cell 220 when viewed toward the surface of the base substrate 100. In addition, the third connection metal layer 330 may be electrically connected to the second N-type semiconductor layer through the second N-type electrode 223 of the second light-emitting cell 220.

The third bump pad 430 may be laminated on the third connection metal layer 330. In addition, the third bump pad 430 may be disposed within the third connection metal layer 330 when viewed toward the surface of the base substrate 100. The edge of the third bump pad 430 may be formed to extend along the edge of the third connection metal layer 330.

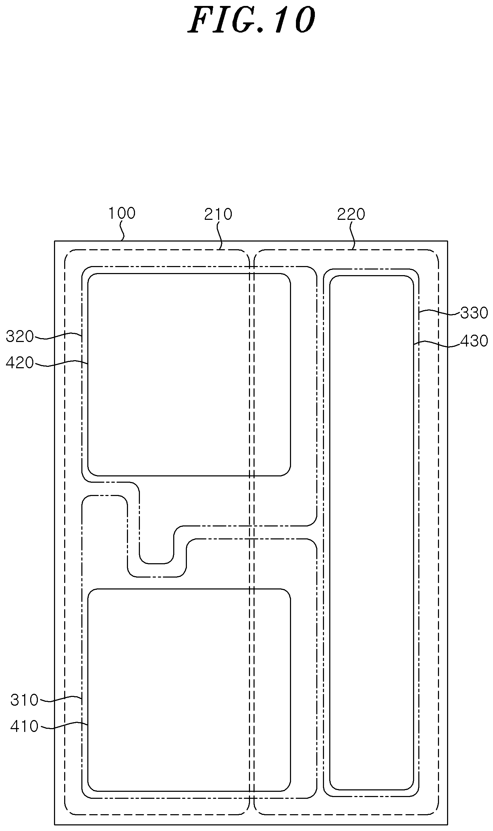

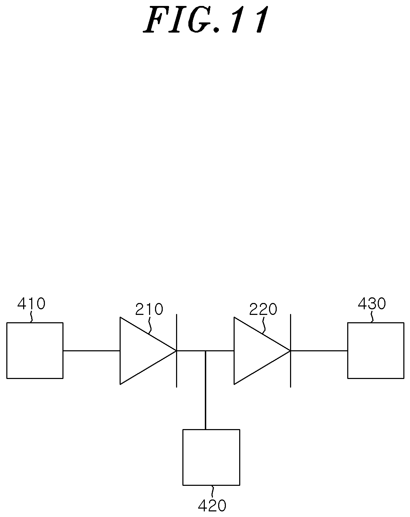

FIG. 10 illustrates the plurality of bump pads 400 exposed on one surface of a light emitting module 10 of the third embodiment, and FIG. 11 is a schematic diagram illustrating a circuit diagram of FIG. 10.

By measuring the first bump pad 410 and the second bump pad 420, it is possible to measure whether the first light-emitting cell 210 emits light properly. By measuring the second bump pad 420 and the third bump pad 430, it is possible to measure whether the second light-emitting cell 220 emits light properly. Therefore, when a problem occurs in the light emission of the light emitting module 10, each light-emitting cell 200 can be individually tested, which makes it easy to identify the problematic light-emitting cell.

Hereinafter, the operation and effects of the light emitting device 1 according to the third embodiment of the present disclosure will be described.

The light emitting device 1 according to the third embodiment of the present disclosure includes two light-emitting cells 200, and can selectively control the light-emitting cells to be driven according to the supplied voltage while effectively reducing the size of the product. For example, the size of the light emitting module 10 may be about 1 mm². More specifically, it may be about 700 µm × 700 µm.

In increasingly miniaturized light emitting devices, the size of the light emitting module 10 inserted into the light emitting device is an important factor in the design of the light emitting device 1. By reducing the size of the light emitting module 10, the light emitting device 1 can be designed more flexibly without spatial limitations and can be used in various spaces.

In addition, in order to implement a panoramic head-up display, which is a vehicle light emitting device, local dimming is required to divide the screen and control the brightness of only a specific part, and in order to implement such a panoramic head-up display, for example, about 300 to 400 light emitting modules 10 may be required. Since a large number of light emitting modules 10 are required, a miniaturized light emitting module 10 that can maintain the brightness level is required. Since the light emitting module 10 according to the third embodiment can provide a miniaturized light emitting module 10, it can be effectively utilized in a light emitting device 1 that requires a large number of such light emitting modules.

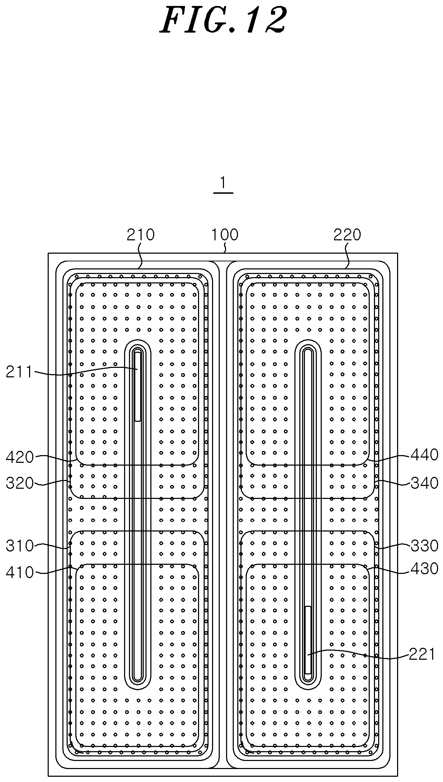

Hereinafter, with reference to FIGS. 12 to 14, a light emitting device 1 according to a fourth embodiment of the present disclosure will be described. Unlike the third embodiment of the present disclosure, in the fourth embodiment, the first light-emitting cell 210 and the second light-emitting cell 220 may not be electrically connected to each other by a metal connection layer.

The first light-emitting cell 210 and the second light-emitting cell 220 may have the same structure, but the present disclosure is not limited thereto, and the structure is capable of generating and emitting light. The structures and shapes of the plurality of light-emitting cells 200 may be at least partially different from each other.

Meanwhile, the first light-emitting cell 210, the second light-emitting cell 220, the first connection metal layer 310, the second connection metal layer 320, the first bump pad 410 and the second bump pad 420 have the same structure as those in the second embodiment, and detailed descriptions thereof will be omitted.

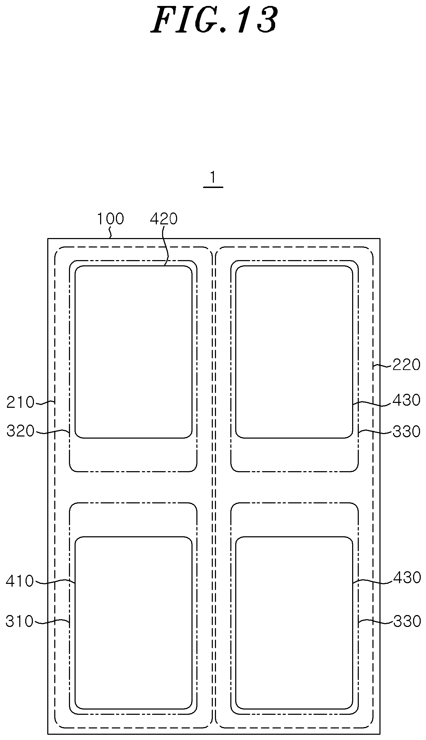

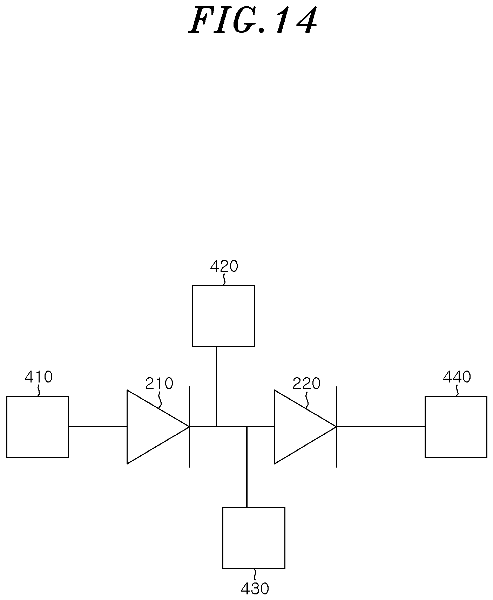

FIG. 13 is a diagram showing one side of the light emitting module 10 on which a plurality of bump pads 400 are exposed, and FIG. 14 is a schematic diagram showing a circuit diagram of the light emitting module 10 of FIG. 13.

By measuring the first bump pad 410 and the second bump pad 420, it is possible to measure whether the first light-emitting cell 210 is operating properly. In addition, by measuring the third bump pad 430 and the fourth bump pad 440, it is possible to measure whether the second light-emitting cell 220 is operating properly. Therefore, when a problem occurs in the operation of the light emitting module 10, it becomes easy to identify which light-emitting cell 200 is defective.

Further, the plurality of bump pads 400 can function to electrically connect the light emitting module 10 to a printed circuit board.

The control unit 20 may supply current to the first bump pad 410 and the second bump pad 420 to cause the first light-emitting cell 210 to emit light. Further, the control unit 20 may supply current to the first bump pad 410 and the fourth bump pad 440 to drive both the first light-emitting cell 210 and the second light-emitting cell 220. In addition, the control unit 20 may operate to connect the first light-emitting cell 210 and the second light-emitting cell 220 in series or in parallel.

Hereinafter, the operation and effects of the light emitting device 1 according to the fourth embodiment of the present disclosure will be described.

The light emitting device 1 according to the fourth embodiment of the present disclosure can include two light-emitting cells 200, so that the size of the light emitting module 10 can be miniaturized. In addition, the first light-emitting cell 210 and the second light-emitting cell 220 can be connected to each other in series or in parallel through the control unit 20 included in the light emitting device 1.

For example, when the supplied voltage is 3 V, if the first light-emitting cell 210 and the second light-emitting cell 220 are connected in series, only one light-emitting cell 200 can be activated. If the first light-emitting cell 210 and the second light-emitting cell 220 are connected in parallel, both of two light-emitting cells 200 can be driven to emit light with low current driving. Therefore, the brightness can be maintained even with low current driving, and the power load on the drive channel is not high, so the generation of heat can be reduced. Accordingly, a separate heat sink for heat dissipation may not be required. Therefore, the light emitting device 1 can be miniaturized while increasing energy efficiency by maximally utilizing the voltage supplied from the battery.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting device comprising:
a base substrate;
a plurality of light-emitting cells arranged on a surface of the base substrate and configured to emit light;
a plurality of connection metal layers connecting the plurality of light-emitting cells and configured to electrically connect the plurality of light-emitting cells in series;
a plurality of bump pads respectively laminated on the plurality of connection metal layers; and
a control unit configured to apply current to at least some of the plurality of bump pads to cause at least one of the plurality of light-emitting cells to emit light.

2. The light emitting device of claim 1, wherein the control unit is configured to apply current to at least some of the plurality of bump pads so that the plurality of light-emitting cells emit light in one of a plurality of preset light-emitting patterns, and the number of the bump pads is less than the number of the plurality of light-emitting patterns.

3. The light emitting device of claim 1, wherein the bump pads have a size smaller than a size of the connection metal layers.

4. The light emitting device of claim 1, wherein an area difference between the plurality of bump pads is within a range of 1% to 20% or less.

5. The light emitting device of claim 1, wherein each of the plurality of bump pads is disposed within an area of two of the plurality of light-emitting cells when viewed toward the surface of the base substrate.

6. The light emitting device of claim 1, wherein each of the plurality of light-emitting cells includes an N-type semiconductor layer and a P-type semiconductor layer sequentially laminated on the base substrate, and
one of the plurality of connection metal layers is electrically connected at one part to the P-type semiconductor layer of one of the plurality of light-emitting cells and at another part to the N-type semiconductor layer of another of the plurality of light-emitting cells.

7. The light emitting device of claim 6, wherein the plurality of light-emitting cells include a first light-emitting cell, a second light-emitting cell, and a third light-emitting cell, and
wherein the plurality of connection metal layers include:
a first connection metal layer electrically connected to the first light-emitting cell;
a second connection metal layer electrically connected to the first light-emitting cell and the second light-emitting cell;
a third connection metal layer electrically connected to the second light-emitting cell and the third light-emitting cell; and
a fourth connection metal layer electrically connected to the third light-emitting cell.

8. The light emitting device of claim 7, wherein the first light-emitting cell includes a first N-type semiconductor layer and a first P-type semiconductor layer sequentially laminated on the base substrate,
the second light-emitting cell includes a second N-type semiconductor layer and a second P-type semiconductor layer sequentially laminated on the base substrate,
the third light-emitting cell includes a third N-type semiconductor layer and a third P-type semiconductor layer sequentially laminated on the base substrate,
the first connection metal layer is electrically connected to the first P-type semiconductor layer,
the second connection metal layer is electrically connected to the first N-type semiconductor layer and the second P-type semiconductor layer,
the third connection metal layer is electrically connected to the second N-type semiconductor layer and the third P-type semiconductor layer, and
the fourth connection metal layer is electrically connected to the third N-type semiconductor layer.

9. The light emitting device of claim 8, wherein the plurality of bump pads include:
a first bump pad laminated on the first connection metal layer;
a second bump pad laminated on the second connection metal layer;
a third bump pad laminated on the third connection metal layer; and
a fourth bump pad laminated on the fourth connection metal layer, and
wherein the first bump pad, the second bump pad, the third bump pad, and the fourth bump pad are arranged sequentially clockwise with respect to a center of the base substrate when viewed toward the surface of the base substrate.

10. The light emitting device of claim 1, wherein the plurality of connection metal layers are formed in different shapes from each other.

11. The light emitting device of claim 1, wherein the plurality of connection metal layers reflect light emitted from the plurality of light-emitting cells toward the base substrate.

12. The light emitting device of claim 1, wherein the plurality of bump pads are arranged symmetrically with respect to a center of the base substrate when the plurality of bump pads are viewed toward the surface of the base substrate.

13. The light emitting device of claim 1, wherein a distance between the plurality of connection metal layers is 15 µm to 20 µm.

14. The light emitting device of claim 1, wherein a convex portion is formed on one of the plurality of connection metal layers to be convex toward another one of the plurality of connection metal layers, and a concave portion is formed on the another one of the plurality of connection metal layers to be concave in a direction away from the one of the plurality of connection metal layers, and the convex portion and the concave portion are arranged to face each other.

15. The light emitting device of claim 1, wherein the plurality of light-emitting cells are arranged in one direction,
wherein each of the plurality of light-emitting cells further includes:
an N-type semiconductor layer laminated on the base substrate;
a P-type semiconductor layer laminated on the N-type semiconductor layer;
an N-type electrode laminated on the N-type semiconductor layer; and
a P-type electrode laminated on the P-type semiconductor layer,
wherein the plurality of connection metal layers are electrically connected to the N-type semiconductor layer and the P-type semiconductor layer through at least one of the N-type electrodes and the P-type electrodes, and
wherein the N-type electrodes of the respective light-emitting cells are arranged in the one direction, and at least one the N-type electrodes is disposed to be offset from another one in a direction perpendicular to the one direction.

16. A light emitting device comprising:
a base substrate;
a plurality of light-emitting cells provided on a surface of the base substrate to be spaced apart from each other and configured to emit light;
a plurality of connection metal layers respectively laminated on the plurality of light-emitting cells to be disposed within the light-emitting cells when viewed toward the surface of the base substrate and electrically connected to the plurality of light-emitting cells;
a plurality of bump pads respectively laminated the plurality of connection metal layers; and
a control unit configured to apply current to at least some of the plurality of bump pads to cause at least one of the plurality of light-emitting cells to emit light.

17. The light emitting device of claim 16, wherein the plurality of light-emitting cells are arranged in one direction,
wherein each of the plurality of light-emitting cells includes:
an N-type semiconductor layer laminated on the base substrate;
a P-type semiconductor layer laminated on the N-type semiconductor layer;
an N-type electrode laminated on the N-type semiconductor layer; and
a P-type electrode laminated on the P-type semiconductor layer,
wherein one of the plurality of connection metal layers is electrically connected to the N-type semiconductor layer through the N-type electrode, and another one of the plurality of connection metal layers is electrically connected to the P-type semiconductor layer through the P-type electrode,
wherein the surface of the base substrate is divided into a first region and a second region by an imaginary line extending from a center of the base substrate in the one direction, and
wherein the N-type electrodes of the respective light-emitting cells are arranged in the one direction, and are alternately arranged in one of the first region and the second region.

18. The light emitting device of claim 16, wherein the connection metal layer electrically connected to one of the plurality of light-emitting cells is disposed within one of the plurality of light-emitting cells when viewed toward the surface of the base substrate, and
the bump pad is disposed within the connection metal layer when viewed toward the surface of the base substrate.

19. A light emitting device comprising:
a base substrate;
a first light-emitting cell provided on a surface of the base substrate;
a second light-emitting cell provided on the surface of the base substrate;
a plurality of connection metal layers laminated on at least one of the first light-emitting cell and the second light-emitting cell and configured to electrically connect the first light-emitting cell and the second light-emitting cell in series or in parallel;
a plurality of bump pads respectively laminated on the plurality of connection metal layers; and
a control unit configured to apply current to at least some of the plurality of bump pads to cause at least one of the first light-emitting cell and the second light-emitting cell to emit light.

20. The light emitting device of claim 19, wherein the plurality of connection metal layers include:
a first connection metal layer electrically connected to the first light-emitting cell;
a second connection metal layer electrically connected to the first light-emitting cell and the second light-emitting cell; and
a third connection metal layer electrically connected to the second light-emitting cell,
wherein the first connection metal layer is disposed so that, when viewed toward the surface of the base substrate, a portion thereof is located within the first light-emitting cell and another portion thereof is located within the second light-emitting cell,
wherein the second connection metal layer is disposed so that, when viewed toward the surface of the base substrate, a portion thereof is located within the first light-emitting cell and another portion thereof is located within the second light-emitting cell, and
wherein the third connection metal layer is disposed to be located within the second light-emitting cell when viewed toward the surface of the base substrate.
